Europäisches Patentamt

European Patent Office

Office européen des brevets

(11) Publication number: **0 065 818**
**B1**

(12) EUROPEAN PATENT SPECIFICATION

(45) Date of publication of patent specification: **30.07.86**

(51) Int. Cl.⁴: **H 01 S 3/19**

(21) Application number: **82302061.5**

(22) Date of filing: **22.04.82**

(54) Phase-locked semiconductor laser device.

(30) Priority: **22.04.81 JP 59851/81**

(43) Date of publication of application:
**01.12.82 Bulletin 82/48**

(45) Publication of the grant of the patent:
**30.07.86 Bulletin 86/31**

(84) Designated Contracting States:
**DE FR GB NL**

(56) References cited:
**FR-A-2 461 380
US-A-3 514 715
US-A-4 121 177
US-A-4 280 108**

**PATENTS ABSTRACTS OF JAPAN, vol.5,
no.186, November 25, 1981, page E-84 858**

(73) Proprietor: **Hitachi, Ltd.**
**5-1, Marunouchi 1-chome
Chiyoda-ku Tokyo 100 (JP)**

(72) Inventor: **Nakashima, Hisao**
**5-1-10-103, Nakaarai Tokorozawa-shi
Saitama-ken (JP)**
Inventor: **Umeda, Jun-ichi**
**612-10, Kamiichibukatamachi Hachioji-shi
Tokyo (JP)**
Inventor: **Matsuda, Hiroshi**
**1-47-1-D101, Akatsuki-cho
Hachioji-shi Tokyo (JP)**
Inventor: **Kuroda, Takao**
**4-14-6, Nishi-koigakubo
Kokubunji-shi Tokyo (JP)**
Inventor: **Kajimura, Takashi**
**2-32-A402, Koyasu-cho
Hachioji-shi Tokyo (JP)**

(74) Representative: **Paget, Hugh Charles Edward
et al**
**MEWBURN ELLIS & CO. 2/3 Cursitor Street
London EC4A 1BQ (GB)**

Courier Press, Leamington Spa, England.

## Description

The present invention relates to a semiconductor laser device; and in particular to a phase-locked semiconductor laser device having a plurality of active regions.

One theme in the development of the semiconductor laser devices for the future is to attain a high output. As a solution to the problem, the phase locked semiconductor laser device has been proposed.

When active regions are juxtaposed at proper intervals and are respectively caused to emit light, the emitted laser beams interfere with one another, and the emitted light of the phase-locked semiconductor laser device becomes as if it were emergent from a single laser element. Owing to the plurality of active regions, operation at high output becomes possible. The phase-locked semiconductor laser device adopts such a principle.

Laser devices of this type have been reported in, for example, the following literature:

(1) Applied Physics Letters, Vol. 33, No. 12, December 1978, pp. 1015—1017, D. R. Scifres et al., "Phase locked semiconductor laser array".

(2) Applied Physics Letters, Vol. 34, No. 15, January 1979, pp. 162—165, W. T. Tsang et al., "A densely packed monolithic linear array of GaAs-$Al_xGa_{1-x}As$ strip buried heterostructure laser".

(3) European Patent Application Publication No. 10949.

In order to achieve a semiconductor laser having a plurality of active regions, it has been proposed to array the active regions in the lateral direction. However, there is extreme difficulty in providing a lateral array of active regions with narrow gaps of 2 to 3 µm or less.

It is known from e.g. US—A—4280108 to form a semiconductor laser device in which the active regions are vertically arrayed. The device has a laminated structure of alternatively stacked first and second semiconductor layers, forming active and cladding layers respectively, so that the second layers have a wider band gap and a lower refractive index than the first layers. The sides of the laminated structure are substantially parallel to the direction of the laser beam and the stacking of the layers is parallel to the sides and perpendicular to the beam. Third semiconductor layers contact each side of the laminated structure, the third layers having a different conductivity type from the first layers.

The device of US—A—4280108 also has means, in the form of electrodes, to inject current into the interface between the first and third layers and the end faces of the device are cleaved to act as an optical resonator for the beam. Therefore US—A—4280108 corresponds to the precharacterising part of claim 1.

However, in the device of US—A—4280108 the third layers are formed by continuations of the first and second layers doped to change the conductivity type. As a result the band gap of the third layers is narrower than that of the first layers, and the refractive index of the third layers is less than the refractive index of the first layers. Therefore the third layers act as an absorption region, increasing the threshold current of the device.

Therefore the present invention proposes that the third layers have a band gap which is not narrower than the band gap of the first layers.

It is easy to array the active regions with narrow gaps in the vertical direction, e.g. by the use of the known molecular beam epitaxy, liquid phase epitaxy or metal organic chemical vapor deposition (MOCVD) techniques. It is possible to inject carriers into the active region in the lateral direction thereof, by burying the active region in a semiconductor of opposite conductivity type thereto.

The second semiconductor layers need not always have the same composition as one another. Also, the first semiconductor layers may be non-doped layers.

A plurality of beams may be generated in the first semiconductor layers serving as active layers. The emitted beams are separated by the second semiconductor layers from one another. However, by causing coherency among the laser beams through the layers, the laser beams from the respective active regions are coherent in wavelength and in phase, and light just as emitted from a single laser can be obtained.

The device may have further laminated structures at each end of the laminated structure in the direction of the laser beam between the laminated structure and the means e.g. cleaved faces, acting as an optical resonator. The conductivity of such further laminated structures should be different from that of the first layers.

The laminated structure and the third layers may be formed on a semi-insulating substrate or on a semi-insulating semiconductor layer on a substrate.

Preferred embodiments of the invention will now be described with reference to the accompanying drawings, wherein:

Figures 1 to 4 are sectional views of parts of a semiconductor laser device useful in understanding the present invention; and

Figures 5 and 6 are sectional views of parts of semiconductor laser devices of the present invention.

An active layer and a cladding layer in the preferred embodiments are not very different from those of conventional semiconductor laser devices.

An example employing a GaAs-GaAlAs system is outlined as follows:

active layer:

$$Ga_{1-x_1}Al_{x_1}As$$

$$0 \leq x_1 \leq 0.3$$

cladding layer:

$$Ga_{1-x_2}Al_{x_2}As$$

$$0.2 \leq x_2 \leq 0.8$$

where

$$x_1 < x_2$$

In addition, a burying layer is made of $Ga_{1-x_3}Al_{x_3}As$ in which $0.2 \leq x_3 \leq 0.8$ holds.

An example employing an InP-InGaAsP system is outlined as follows:

active layer:

$$In_xGa_{1-x}As_yP_{1-y}$$

$$0.6 \leq x \leq 0.9, \qquad 0.1 \leq y \leq 0.8$$

Here, in order to establish lattice matching with InP, the following relation holds:

$$y = 2.16(1-x)$$

In the case of an oscillation wavelength of 1.2 to 1.3 μm, x=0.75 and y=0.5 or so.

InP is used for the cladding layer and the burying layer.

The thickness of the active layer in the case of the GaAs—GaAlAs system is 1 μm—0.005 μm, preferably 0.1 μm—0.05 μm. On the other hand, the thickness of the intermediate cladding layer is set within a range of 5 μm—0.005 μm, preferably 0.2—0.5 μm. The thicknesses of the outermost cladding layers which are disposed at the top and bottom of the lamination consisting of the active layers and the cladding layers are often made 1—3 μm or so.

The width of a mesa region including the active layers is usually 1—3 μm. Since the size of the emission region depends, at least, upon the diffusion length of the carriers, the width of the mesa region is determined in consideration of this point.

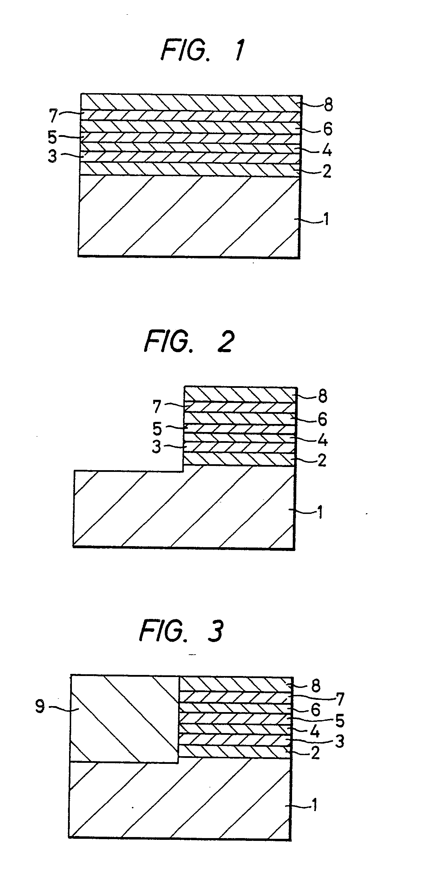

Figure 1 shows an arrangement in which n-type $Ga_{0.7}Al_{0.3}As$ layers (doped with Sn; carrier concentration: $5 \times 10^{17}$ cm$^{-3}$) (2, 4, 6, 8) and GaAs layers (undoped; carrier concentration: $1 \times 10^{16}$ cm$^{-3}$) (3, 5, 7) are alternately stacked by the molecular-beam epitaxial method on a semi-insulating GaAs substrate crystal 1. The composition of the active layers depends upon the oscillation wavelength, and GaAlAs is used for the active layer at some selected wavelengths. Such points are quite the same as in the case of conventional semiconductor lasers. The first and last n-type $Ga_{0.7}Al_{0.3}As$ layers (2 and 8) are 1 μm thick, while the intermediate n-type $Ga_{0.7}Al_{0.3}As$ layers (4, 6) are 0.5 μm thick in this case. The composition and thickness of the intermediate GaAlAs layers (4, 6) have great influences on the interactions of laser beams emergent from the respective active regions. Accordingly, the composition of the first and last GaAlAs layers (2 and 8) and that of the intermediate GaAlAs layers (4, 6) may well be made different. The mole fraction of AlAs in the composition of the first and last GaAlAs layers (2, 8) may be at least 0.3, while the mole fraction of AlAs in the composition of the intermediate GaAlAs layers (4, 6) should desirably be at most 0.35. This relation of the mole fractions of AlAs corresponds to the case where the active layers (3, 5, 7) are made of GaAs. In a case where the active layers are also made of

GaAlAs so as to render the wavelength of the laser beam short, the relation may be considered by shifting the composition of the sandwiching GaGlAs a component in the composition of the active layer GaAlAs. In addition, the thickness of each intermediate N-type GaAlAs layer (2, 4) is allowed to be 5—.005 μm. The thickness of each GaAs layer (3, 5, 7) being the active layer is 0.1 μm in the present example, but it is generally allowed to be 1—0.005 μm or so.

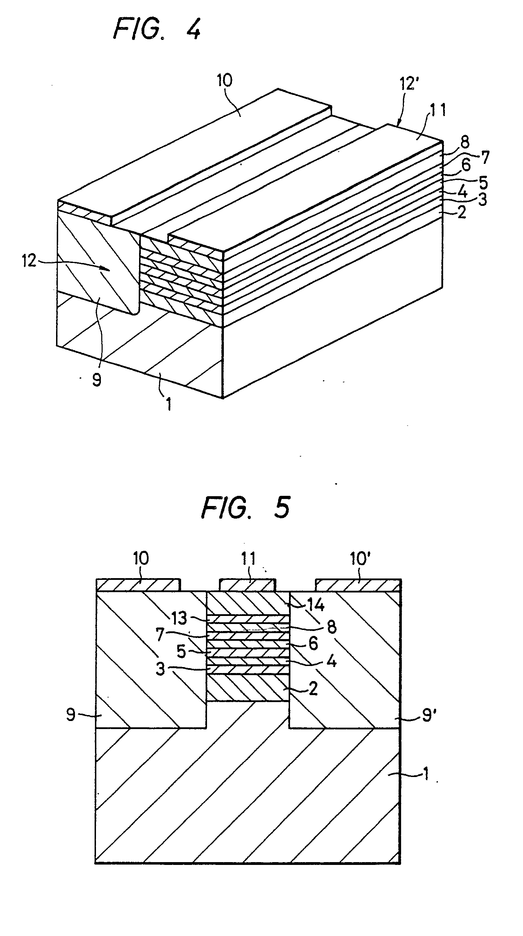

The multilayer on the substrate is etched into the shape of a mesa down to the substrate crystal 1 by the use of photolithography employing a photoresist. This state is shown in Figure 2. Thereafter, using the well-known liquid phase epitaxy, a recess formed by the mesa etching is filled up with a p-type $Ga_{0.7}Al_{0.3}As$ layer (doped with Ge; carrier concentration $1 \times 10^{18}$ cm$^{-3}$) 9 (refer to Figure 3). Subsequently, Cr-Au 10 and Au-Ge-Ni 11 are respectively deposited on the p-type $Ga_{0.7}Al_{0.3}As$ layer 9 and the n-type $Ga_{0.7}Al_{0.3}As$ layer 8 by vacuum evaporation so as to dispose ohmic electrodes on the respective regions. The spacing of the electrodes is 4 μm, including 2 μm on either side of the p-n junction. Thereafter, the crystal is cleaved to form reflecting faces 12 and 12' which construct an optical resonator. Figure 4 shows a perspective view of the semiconductor laser device finished. Figures 1 to 3 are sectional views taken along a plane perpendicular to the travelling direction of the laser beam. In this arrangement having a cavity length of 300 μm, there are the three active regions. In principle, however, there may be any number of active regions. It may be designed, depending upon bias current and thermal radiation.

The semiconductor laser device thus fabricated has a threshold current of 60 mA and an output of 300 mW. The spread of a far field pattern is 20° in a direction parallel to the growth plane and 20° in a direction perpendicular thereto and is isotropic. In addition, a single longitudinal mode and a single transverse mode are established. In the structure of Figure 4, the conductivity types of the buried layer and the burying layer may of course be converse to the aforementioned ones.

Embodiment 1

A first embodiment of the invention will now be described with reference to Figure 5, which shows:

a sectional view taken along a plane perpendicular to the travelling direction of a laser beam. The present embodiment is such that carriers are injected from both sides so as to attain a greater optical output. The multilayer is formed on a substrate by the molecular beam epitaxy as in Embodiment 1 stated before. The compositions, thickness and carrier concentrations of the respective layers are as stated in Embodiment 1. The layers 2, 4, 6, 8 and 14 are n-type $Ga_{0.7}Al_{0.3}As$ layers, while the layers 3, 5, 7 and 13 are GaAs active layers. The other conditions are the same as in Embodiment 1. The wafer is etched into the shape of a mesa so as to leave a strip being 2 μm wide, and the parts etched off are filled up with p-type $Ga_{0.7}Al_{0.3}As$ layers 9, 9' by liquid phase epitaxy. Ohmic electrodes 10, 10' and 11 are described before. In the case of the present embodiment, there are four active regions, the threshold current is 80 mA, and the optical output is 800 mW.

Embodiment 2

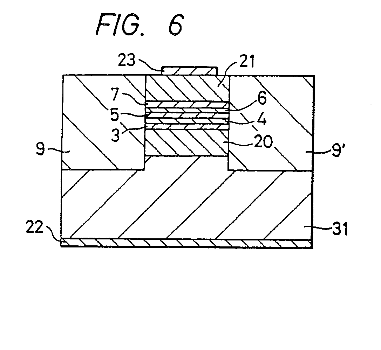

The second embodiment corresponds to a case where n-type GaAs is used for a substrate crystal. Figure 6 shows a sectional view of the embodiment. On the n-type GaAs substrate crystal 31 (doped with Si; carrier concentration: $1\times10^{18}$ $cm^{-3}$), there are grown by liquid phase epitaxy a semi-insulating $Ga_{0.7}Al_{0.3}As$ layer 20 (resistivity $10^4\Omega \cdot cm$; thickness: 2 μm), a lamination in which p-type GaAs layers or p-type GaAlAs layers (3, 5 and 7) (doped with Zn; carrier concentration: $3\times10^{17}$ $cm^{-3}$; thickness: 0.1 μm) and p-type $Ga_{0.7}Al_{0.3}As$ layers (4 and 6) (doped with Zn; carrier concentration: $8\times10^{17}$ $cm^{-3}$; thickness: 0.2 μm) are alternately stacked, and a p-type $Ga_{0.7}Al_{0.3}As$ layer 21 (doped with Zn; carrier concentration: $8\times10^{17}$ $cm^{-3}$; thickness 2 μm). The laminated wafer having the multilayer structure is etched down to the substrate crystal 31 into the shape of a mesa by the use of the photolithography employing a photoresist. Thereafter, the resulting recesses are filled up with n-type $Ga_{0.7}Al_{0.3}As$ layers 9 and 9' (doped with Sn; carrier concentration: $5\times10^{17}$ $cm^{-3}$) by the liquid phase epitaxy, so that again the composition of the p-type $Ga_{0.7}Al_{0.3}As$ layers 9, 9' is such that they have a band gap not narrower than, and a refractive index not higher than the active layers 3, 5, 7, 13. Ohmic electrodes 22 and 23 are respectively formed on the p-type $Ga_{0.7}Al_{0.3}As$ layer 21 and the n-type GaAs substrate crystal 31. Subsequently, the crystal is cleaved along planes perpendicular to the travelling direction of a laser beam so as to construct an optical resonator. Here, the semi-insulating $Ga_{0.7}Al_{0.3}As$ layer 20 may be grown with a Ga solution dry-baked at 850°C in hydrogen gas of high purity for 4 hours. In some cases, it may well be doped with Cr, Fe or the like. The thickness of each active layer, and the composition and thickness of each GaAlAs cladding layer are the same as in Embodiment 1. The cavity length is 300 μm. The threshold current is 80 mA, and the optical output is 750 mW.

In the preferred embodiments, the semiconductor laser device has a structure in which the mesa region including the plurality of active layers is buried on both sides thereof. With the level of present-day semiconductor machining technology, the machining precision of the mesa region is very high, and the controllability of the machining is good. Accordingly, emission spots in the respective active layers do not involve any positional deviation. It can therefore be said that the structure of the present embodiments is very effective for attaining a high output.

Needless to say, as regards the semiconductor materials, the present invention is not restricted to semiconductor lasers of the GaAlAs-GaAs system, but it is similarly applicable to semiconductor lasers employing a compound semiconductor of a ternary system such as GaAlP, InGaP, GaAsP or GaAsSb system; a compound semiconductor of a quaternary system such as InGaAsP, GaAlAsSb or GaAlAsP system; etc. Naturally, these semiconductor lasers fall within the scope of the present invention.

Claims

1. A semiconductor laser device comprising: a laminated structure (2, 3, 4, 5, 6, 7, 8, 13, 14) with two side faces both substantially parallel to the direction of a laser beam generated by the device, the laminated structure having alternate first (3, 5, 7, 13) and second (2, 4, 6, 8, 14) semiconductor layers stacked in a direction substantially parallel to the side faces and substantially perpendicular to the direction of the laser beam, the first semiconductor layers (3, 5, 7, 13) having substantially the same composition, the second semiconductor layers (2, 4, 6, 8, 14) having a wider band gap and a lower refractive index than the first semiconductor layers (3, 5, 7, 13);

third semiconductor layers (9, 9') contacting each side face of the laminated structure, thereby forming interfaces with the first semiconductor layers (3, 5, 7, 13), the conductivity type of the third semiconductor layers (9, 9') being different from that of the first semiconductor layers (3, 5, 7, 13), the third semiconductor layers (9, 9') having a refractive index which is not higher than the refractive index of the first semiconductor layers (3, 5, 7, 13);

means (10, 10', 11) to inject current into the interface between the first semiconductor layers (3, 5, 7, 13) and the third semiconductor layers (9, 9'); and

means (12, 12') acting as an optical resonator for laser beam;

characterised in that:

the third semiconductor layers (9, 9') have a band gap which is not narrower than the band gap of the first semiconductor layers (3, 5, 7, 13).

2. A semiconductor laser device according to claim 1 having further laminated structures (16, 16') at each end of the laminated structure in the direction of the laser beam, between the laminated structure and the means (12, 12') acting as an optical resonator, the conductivity of the further laminated structures being different from that of the first semiconductor layers (3, 5, 7, 13).

3. A semiconductor laser device according to claim 1 or claim 2, wherein the laminated structure and the third semiconductor layer (9, 9') are formed on a semi-insuating semiconductor substrate (1).

4. A semiconductor laser device according to claim 1 or claim 2, wherein at least the laminated structure is disposed on a semi-insulating semiconductor layer (20) over a semiconductor substrate (31).

## Patentansprüche

1. Halbleiterlaservorrichtung umfassend:
einen geschichteten Aufbau (2, 3, 4, 5, 6, 7, 8, 13, 14) mit zwei Seitenflächen, die beide zur Richtung eines von der Vorrichtung erzeugten Laserstrahls im wesentlichen parallel verlaufen, wobei der geschichtete Aufbau abwechselnd erste (3, 5, 7, 13) und zewite (2, 4, 6, 8, 14) Halbleiterschichten aufweist, die in einer zu den Seitenflächen im wesentlichen parallelen und zur Richtung des Laserstrahls im wesentlichen senkrechten Richtung gestapelt sind, wobei die ersten Halbleiterschichten (3, 5, 7, 13) im wesentlichen die gleiche Zusammensetzung haben und die zweiten Halbleiterschichten (2, 4, 6, 8, 14) einen größeren Bandabstand und einen niedrigeren Brechungsindex aufweisen als die ersten Halbleiterschichten (3, 5, 7, 13);
dritte Halbleiterschichten (9, 9'), die mit jeder Seitenfläche des geschichteten Aufbaus in Berührung stehen und dadurch mit den ersten Halbleiterschichten (3, 5, 7, 13) Grenzflächen bilden, wobei der Leitfähigkeitstyp der dritten Halbleiterschichten (9, 9') von dem der ersten Halbleiterschichten (3, 5, 7, 13) verschieden ist, und wobei die dritten Halbleiterschichten (9, 9') einen Brechungsindex aufweisen, der nicht größer ist als der Brechungsindex der ersten Halbleiterschichten (3, 5, 7, 13);
eine Einrichtung (10, 10') zur Injektion von Strom in die Genzfläche zwischen den ersten Halbleiterschichten (3, 5, 7, 13) und den dritten Halbleiterschichten (9, 9'); und
eine Einrichtung (12, 12') die als optischer Resonator für den Laserstrahl wirkt;
dadurch gekennzeichnet, daß die dritten Halbleiterschichten (9, 9') einen Bandabstand aufweisen, der nicht schmäler ist als der Bandabstand der ersten Halbleiterschichten (3, 5, 7, 13).

2. Halbleiterlaservorrichtung nach Anspruch 1, die an jedem in Richtung des Laserstrahls gelegenen Ende des geschichteten Aufbaus zwischen diesem und der als optischer Resonator wirkenden Einrichtung (12, 12') weitere geschichtete Strukturen (10, 10') aufweist, wobei der Leitfähigkeitstyp der weiteren geschichteten Strukturen von dem der ersten Halbleiterschichten (3, 5, 7, 13) verschieden ist.

3. Halbleiterlaservorrichtung nach Anspruch 1 oder 2, wobei der geschichtete Aufbau und die dritten Halbleiterschichten (9, 9') auf einem halbisolierenden Halbleitersubstrat (1) ausgebildet sind.

4. Halbleiterlaservorrichtung nach Anspruch 1 oder 2, wobei mindestens der geschichtete Aufbau auf einer Halbisolierenden Halbleiterschicht (20) über einem Halbleitersubstrat (31) angeordnet ist.

## Revendications

1. Dispositif laser à semiconducteurs, comprenant:
une structure stratifiée (2, 3, 4, 5, 6, 7, 8, 13, 14) comportant deux faces latérales toutes deux essentiellement parallèles à la direction d'un faisceau laser produit par le dispositif, la structure stratifiée comportant des premières couches semiconductrices (3, 5, 7, 13) et des secondes couches semiconductrices (2, 4, 6, 8, 14), qui alternent et sont empilées suivant une direction essentiellement parallèle aux faces latérales et essentiellement perpendiculaire à la direction du faisceau laser, les premières couches semiconductrices (3, 5, 7, 13) possédant essentiellement la même composition, les secondes couches semiconductrices (2, 4, 6, 8, 14) possédant une bande interdite plus large et un indice de réfraction plus faible que les premières couches semiconductrices (3, 5, 7, 13),
des troisièmes couches semiconductrices (9, 9') contactant chaque face latérale de la structure stratifiée en formant ainsi des interfaces avec les premières couches semiconductrices (3, 5, 7, 13), le type de conductivité des troisièmes couches semiconductrices (9, 9') étant différent de celui des premières couches semiconductrices (3, 5, 7, 13), les troisièmes couches semiconductrices (9, 9') possédant un indice de réfraction qui n'est pas supérieur à l'indice de réfraction des premières couches semiconductrices (3, 5, 13),
des moyens (10, 10', 11) servant à injecter un courant dans l'interface entre les premières couches semiconductrices (3, 5, 7, 13) et les troisièmes couches semiconductrices (9, 9'); et
des moyens (12, 12') agissant en tant que résonateur optique pour le faisceau laser; caractérisé en ce que:
les troisièmes couches semiconductrices (9, 9') possèdent une bande interdite qui n'est pas plus étroite que la bande interdite des premières couches semiconductrices (3, 5, 7, 13).

2. Dispositif laser à semiconducteurs selon la revendication 1, comportant des structures stratifiées supplémentaires (16, 16') à chaque extrémité de la structure stratifiée suivant la direction du faisceau laser, entre la structure stratifée et les moyens (12, 12') agissant en tant que résonateur optique, la conductivité des structures stratifiées supplémentaires étant différente de celle des premières couches semiconductrices (3, 5, 7, 13).

3. Dispositif laser à semiconducteurs selon la revendication 1 ou 2, dans lequel la structure stratifiée et la troisième couche semiconductrice (9, 9') sont formées sur un substrat semiconducteur semi-isolant (1).

4. Dispositif laser à semiconducteurs selon la revendication 1 ou 2, dans lequel au moins la structure stratifiée est disposée sur une couche semiconductrice semi-isolante (20) sur un substrat semiconducteur (31).

## FIG. 1

## FIG. 2

## FIG. 3

FIG. 4

FIG. 5

FIG. 6